# EUROPÄISCHE PATENTSCHRIFT

(11) **EP 0 596 349 B1**
(45) Veröffentlichungstag und Bekanntmachung des Hinweises auf die Patenterteilung: **06.12.1995**
(21) Anmeldenummer: 93117203.5
(22) Anmeldetag: 23.10.1993
(51) Int. Cl.: H05K 7/14

(54) **Elektrischer Baugruppenträger**
Electric rack
Support pour installation électrique

(30) Priorität: 06.11.1992 DE 4237447
(43) Veröffentlichungstag der Anmeldung: 11.05.1994
(73) Patentinhaber: Licentia Patent-Verwaltungs-GmbH, 60596 Frankfurt (DE)
(72) Erfinder: Haxel, Gerd, Dr.-Ing., D-63500 Seligenstadt (DE); Ponto, Roberto, D-63500 Seligenstadt (DE); Bohnenberger, Willy, Dipl.-Ing., D-63533 Mainhausen (DE)
(74) Vertreter: Erbacher, Alfons, Dipl.-Ing.

(56) Entgegenhaltungen:
- EP-A- 0 415 246
- EP-A- 0 508 002
- DE-A- 3 241 067

## Beschreibung

Die Erfindung bezieht sich auf einen Baugruppenträger für elektrische Baugruppen mit zwei Seitenwänden, zwischen denen wenigstens vier Profilschienen angeordnet sind, deren Stirnseiten nahe an den Ecken der Seitenwände an diesen befestigt sind, wobei mit den Profilschienen Führungshalter verbunden sind, in die die elektrischen Baugruppen einsetzbar sind.

Derartige Baugruppenträger sind z. B. durch das 19"-Aufbausystem bekannt. In dem "Handbuch des 19"-Aufbausystems", Markt & Technik-Verlag, 1986, sind Baugruppenträger der oben angegebenen Art auf den Seiten 95 bis 118 beschrieben.

Die Dokumente DE-A-3241067 und EP-A-0508002 offenbaren ebenfalls Baugruppenträger der oben angegebenen Art.

An den Profilschienen werden nicht nur die Führungshalter und Seitenwände sondern auch andere Bauteile befestigt. An den vorderen Profilschienen werden vielfach die Baugruppen mit ihren Frontplatten angeschraubt. Mit den hinteren Profilschienen sind flache oder Z-förmige Metallschienen verbunden, an denen Federleisten befestigt sind, oder es werden Rückwände in Form von gedruckten Schaltungen mit Steckverbindern montiert. Darüberhinaus werden vielfach durchbrochene Abdeckbleche auf der Oberseite und der Unterseite der Baugruppenträger angeordnet, die einerseits eine elektromagnetische Abschirmung erzeugen und andererseits den Durchtritt von Kühlluft zulassen sollen. Diese Abdeckbleche werden ebenfalls an den Profilschienen befestigt. Zur Befestigung der Frontplatten und der rückwärtigen Metallschienen an den Stirnseiten der Profilschienen sind Nuten mit kreuzförmigen Querschnitten in den Profilschienen vorgesehen.

Die Nuten erstrecken sich in Richtung der Breite der Profilschienen und enthalten Gleitmuttern oder Gewindeleisten, die in die Querausnehmungen eingesetzt sind. Diese kreuzförmigen Nuten beanspruchen einen gewissen Längenabschnitt der Profilschienen. Ein weiterer Längenabschnitt ist für die Befestigung der Führungshalter vorgesehen, die vielfach Führungselemente zum genauen Positionieren und Rastelemente zum Befestigen der Führungshalter an den Profilschienen aufweisen. Darüberhinaus weisen die Profilschienen an den Stirnseiten Gewindelöcher auf, für die Abschnitte mit größeren Wandstärken benötigt werden.

Die vorstehend beschriebenen Gegebenheiten führen dazu, daß die Profilschienen in Tiefenrichtung des jeweiligen Baugruppenträgers eine gewisse Ausdehnung haben. Die Profilschienen behindern aber, insbesondere wenn sie eine gewisse Ausdehnung haben, die Zufuhr von Kühlluft zu denjenigen elektrischen oder elektronischen Bauelementen, die oberhalb der Profilschienen auf Baugruppen angeordnet sind.

Der Erfindung liegt das Problem zugrunde, eine Montage verschiedener Baugruppenträger bzw. Baugruppenträger aufbauender Elemente zu optimieren. Die Optimierung wird insbesondere unter den Aspekten einer vorteilhaften Kühlluftführung, der Platz- und Materialeinsparung, der Montageerleichterung, der elektrischen Abschirmung und den damit verbundenen Kostenersparnissen bzw. verbesserten Betriebsbedingungen durchgeführt. Insbesondere wird auf die Kombination der einzelnen Optimierungsbedingungen verwiesen die zu einem besonders effektiven und erfindungsgemäßen Erreichen der beschriebenen Aufgabestellung führt. Ein besonderer Aspekt der Erfindung liegt darin, daß durch die wahlweise Verknüpfung der bevorzugten, erfindungsgemäßen Ausführungen mehrere Aspekte gleichzeitig und in einer sich gegenseitig verstärkenden Weise kombiniert werden können.

Weitere Beschreibungen des Standes der Technik finden sich in den Offenlegungsschriften DE-4114484-A1 und DE-3241067-A1 sowie DE-3928461-A1 und DE-8714497-U, die hiermit als in die Beschreibung des Standes der Technik dieser Anmeldung integriert angesehen werden. In den obengenannten Offenlegungsschriften werden die Baugruppen ihrem prinzipiellen Aufbau nach beschrieben aber die bezeichneten Probleme werden weder aufgegriffen noch gelöst.

Einem Aspekt der vorliegenden Erfindung liegt das Problem zugrunde, für einen Baugruppenträger der eingangs beschriebenen Art in Tiefenrichtung des Baugruppenträgers möglichst kurze Profilschienen zu entwickeln, an denen Abdeckbleche befestigt werden können. Dies insbesondere um Material für die Bauteile zu sparen aber auch um erfindungsgemäß eine vorteilhafte Führung der Kühlluft in den Randbereichen zu ermöglichen. Diese Profilschienen können vorzugsweise von den Stirnseiten ausgehende Nuten mit kreuzförmigen Querschnitten aufweisen.

Die Aufgabe wird erfindungsgemäß dadurch gelöst, daß in einem Abschnitt der jeweiligen Profilschiene, der ein in Längsrichtung verlaufendes Loch für Schraubbefestigungen der Seitenwände aufweist, in das genannte Loch einmündende, mit den Mittellinien rechtwinklig zur Mittellinie dieses Lochs verlaufende Löcher vorgesehen sind, die von einer Auflagefläche der Profilschiene für ein Abdeckblech aus zum Befestigen des Abdeckblechs zugänglich sind, wie in Anspruch 1 offenbart. Bei diesen Profilschienen ist ein Abschnitt der Profilschiene doppelt, nämlich für die Befestigungsmittel von Seitenwänden und von Abdeckblechen ausgenutzt, ohne daß in Tiefenrichtung des Baugruppenträgers zusätzlich Raum beansprucht wird. Die Profilschienen können daher kürzer sein, wodurch der für den Kühlluftdurchtritt verfügbare Raum vergrößert wird. Außerdem ist damit eine Materialeinsparung verbunden, da der Querschnitt der Profilschienen kleiner wird. Auch das Gewicht des Baugruppenträgers wird geringer.

Bei einer bevorzugten Ausführungsform gehen die Löcher nahe an der Auflagefläche in eine Ausnehmung über, die an Köpfe von Schrauben mit tellerförmigen Rändern angepaßt ist, wobei die Ränder im Durchmesser größer sind als Durchlässe für Schrauben im Abdeckblech. Bei dieser Ausführungsform werden die Abdeckbleche durch die Ränder der in die Löcher eingesetzten Schrauben gehalten, während die dicker ausgebildeten Kopfmitten in der Ausnehmung sitzen. Die Befestigungsmittel für die Abdeckbleche überragen die Abdeckbleche daher nur geringfügig, d. h. der in der Höhe von den Baugruppenträgern beanspruchte Raum wird durch die einfache, kostengünstige Art der Befestigung der Abdeckbleche nicht vergrößert.

Es ist günstig, wenn die Abdeckbleche mit Löchern für den Luftdurchlaß versehen sind, die im Raster eines genormten Maßes gleichmäßig auf dem jeweiligen Abdeckblech verteilt sind, wobei die Löcher in den Profilschienen in einer Reihe in gleichem Raster oder einem Vielfachen dieses Rasters angeordnet sind wie die in einer Reihe angeordneten Löcher der Abdeckbleche. Bei dieser Ausführungsform können die Abdeckbleche aus vorhandenen, gelochten Tafeln schnell und einfach auf die jeweils für einen bestimmten Baugruppenträger erforderliche Größe zugeschnitten werden.

Bei einer anderen bevorzugten Ausführungsform enthalten die Profilschienen jeweils eine in Längsrichtung verlaufende, im Abstand von der Reihe der Löcher angeordnete, von einer baugruppenaußenseitig angeordneten Profilschienenbreitseite ausgehende Nut, in die abgewinkelte Enden der Abdeckbleche ragen und durch Kontaktfedern elektrisch leitend mit wenigstens einer Wand der Nut verbunden sind. Mit dieser Vorrichtung läßt sich eine gute Abschirmung an den Rändern der Abdeckbleche erreichen.

Besonders günstig ist es, wenn die Kontaktfedern U-förmig geformt sind und ein Schenkel der Kontaktfedern mindestens einen federnd vorspringenden Finger enthält. Der bzw. die Finger sind insbesondere aus dem Schenke durch Schneiden eines Streifens hergestellt. Diese erfindungsgemäße Ausführung bringt insbesondere bei der Montage von Baugruppenträgern der vorstehend beschriebenen Art wesentliche Vorteile.

Die federnd vorspringenden Finger erlauben das Aufstecken der Kontaktfedern auf die abgewinkelten Enden der Abdeckbleche vor dem Zusammenfügen von Abdeckblechen und Profilschienen.

Die Kontaktfedern haften auf den Rändern und können bei der Montage der Abdeckbleche zusammen mit diesen in die Profilschienennuten eingedrückt werden. Die beiden Schenkel der jeweiligen Kontaktfeder legen sich je an eine Nutwand und an die innere Seite des abgewinkelten Endes an. Bei kleinen Nuten, in die bei der Montage eines Geräts zuerst eine Kontaktfeder mit U-förmiger Wölbung eingesetzt wird, lassen sich abgewinkelte Enden von Hand nur schwer einsetzen, da der eine Schenkel der Feder von der Nutwand gelöst werden muß.

Das Einfügen ist daher umständlich und gelingt meist nicht beim ersten Versuch. Hierdurch ergeben sich längere Montagezeiten. Diese Schwierigkeiten werden mit der oben beschriebenen Ausbildung der Kontaktfeder beseitigt.

Eine andere, bevorzugte und besonders vorteilhafte Ausführung besteht darin, daß das jeweils oben oder unten am Baugruppenträger angeordnete Abdeckblech parallel zu den Seitenwänden des Baugruppenträgers verlaufende abgewinkelte Enden hat, die der Innenseite der Seitenwand gegenüber stehen, und daß je eine, einen S-förmigen Querschnitt aufweisende Kontaktfeder die Längsränder einer Seitenwand und eines abgewinkelten Endes umgreift. Mit dieser Ausführungsform läßt sich eine sehr gute Abschirmung zwischen den Abdeckblechen und den Seitenwänden erreichen. Ein großer Vorteil dieser Vorrichtung ist darin zu sehen, daß keine Schraubverbindungen zwischen den Seitenwänden und Abdeckblechen notwendig sind. Die S-förmigen Federn können von Hand schnell montiert werden. Aufgrund der Federwirkung haften die Kontaktfedern bereits am Rand eines Bauteils, d. h. die Kontaktfedern können zuerst über den Rand der jeweiligen Seitenwand oder des Abdeckblechs geschoben werden; und danach wird bei der Montage des Abdeckblechs am Baugruppenträger die Kontaktfeder über den gegenüberstehenden Rand gedrückt.

Die Verwendung der S-förmigen Kontaktfedern erlaubt in Verbindung mit den oben beschriebenen Maßnahmen zur Kontaktierung der Abdeckbleche an den Profilschienen die Verwendung sehr einfacher Abdeckbleche, die über die gesamte Fläche gelocht sind.

Es ist nicht mehr notwendig, die Randbereiche der Abdeckbleche so auszubilden, daß Schraubverbindungen oder andere mit zeitraubenden Montagearbeiten zusammenhängende Verbindungen angebracht werden können.

Die Anpassung von Abdeckblechen an die jeweilige Baugruppenträgergröße beschränkt sich auf das Ausschneiden eines an die Größe des Baugruppenträgers abgestimmten Blocks und das Umbiegen der Kanten. Da die Abdeckbleche aus gelochten Blechen auf relativ einfache Art hergestellt werden können, ergeben sich bedeutende Einsparungen bei der Fertigung und Montage.

Die an der Rückseite des Baugruppenträgers angeordneten Federleisten weisen vielfach nach hinten vorstehende Pfosten auf, an denen Leitungen mit an sich bekannten Anschlußtechniken befestigt werden können. Häufig sind die Federleisten mit einer Rückwandleiterplatte verbunden, in die die Pfosten eingepreßt oder eingelötet sind. Die Rückwandleiterplatte und die Leitungen stellen gewünschte Verbindungen zwischen den Pfosten der Federleisten her, die den einzelnen Baugruppen zugeordnet sind. Vielfach muß die Rückseite eines Baugruppenträgers zur Vermeidung von Störstrahlungen abgeschirmt werden. Bei einer zweckmäßigen Ausführungsform hat eine rückseite Abdeckhaube am Baugruppenträger an die rückwärtige Ausdehnung des Baugruppenträgerabdeckraums angepaßte, mit abgewinkelten oberen und unteren Randzonen versehene Wände, deren Randbereich jeweils mit einer der rückwärtigen Profilschienen durch in Profilschienennuten eingesetzte leitende Federn kontaktiert sind, wobei die sich bis zum Ende des Baugruppenträgerabdeckraums erstreckenden Seitenwände mit den Randzonen über Federn leitend verbunden sind, und wobei eine rückseitige Bodenplatte der Abdeckhaube abgewinkelte Randzonen hat, die den Innenseiten der Seitenwände unter Zwischenschaltung elektrisch leitender Federn gegenüberstehen. Mit dieser Anordnung wird auf einfache Weise eine gute Abschirmung erreicht.

Vorzugsweise weisen die beiden Seitenwände nahe an ihren rückseitigen Enden je einen zum Inneren des Abdeckraums hin gerichteten Befestigungswinkel auf, der einen gegen den abgebogenen Rand der Rückwand der Abdeckhaube zurückgesetzten Abschnitt hat und an dem die Rückwand angeschraubt ist.

Die Abdeckhaube läßt sich schnell und einfach montieren. Zweckmäßigerweise sind die leitenden Federn an den abgewinkelten Rändern angeklebt. Die oben beschrieben Vorrichtung zum elektromagnetischen Abschirmen läßt sich für sich bei unterschiedlichen Baugruppenträgern einsetzen und stellt demnach eine weitere bevorzugte Ausführung der erfinderischen Idee dar.

Die Erfindung wird im folgenden anhand eines in einer Zeichnung dargestellten Ausführungsbeispiels näher beschrieben, aus dem sich weitere Einzelheiten, Merkmale und Vorteile ergeben.

Es zeigen:
- Fig. 1: einen Baugruppenträger im Längsschnitt;
- Fig. 2a: eine Schraubstelle zur Befestigung eines oberen oder unteren Abdeckblechs an dem Baugruppenträger gem. Fig. 1 im Schnitt;
- Fig. 2b: ein Abdeckblech in Seitenansicht von oben;
- Fig. 2c: eine Kontaktfeder in perspektivischer Ansicht;
- Fig. 3: einen Schnitt längs der Linien I-I des in Fig. 1 dargestellten Baugruppenträgers;
- Fig. 4: den rückwärtiogen Teil einer anderen Ausführungsform eines Baugruppenträgers im Längsschnitt und
- Fig. 5: den Baugruppenträger gem. Fig. 4 im Schnitt längs der Linien II-II.

Ein Baugruppenträger 1 enthält zwei Seitenwände 2, von denen der Längsschnitt nur eine zeigt, und vier Profilschienen 3, 4, 5, 6, die bei einem kürzeren Baugruppenträger verwendet werden, sowie zwei weiteren Profilschienen 6a, 7, die bei einem Baugruppenträger mit größerer Tiefe zusätzlich vorgesehen sind.

Die Profilschienen 3, 4, 5, 6 sind jeweils nahe an den Ecken der Seitenwände 2 an diesen befestigt. Bei dem vorstehend erwähnten Baugruppenträger mit größerer Tiefe sind die Profilschienen 6a, 7 nahe an den hinteren Ecken der Seitenwände befestigt, während die Profilschienen 5, 6 im Abstand von den hinteren Profilschienen am Ende des den Baugruppen zugeordneten Raums angeordnet sind.

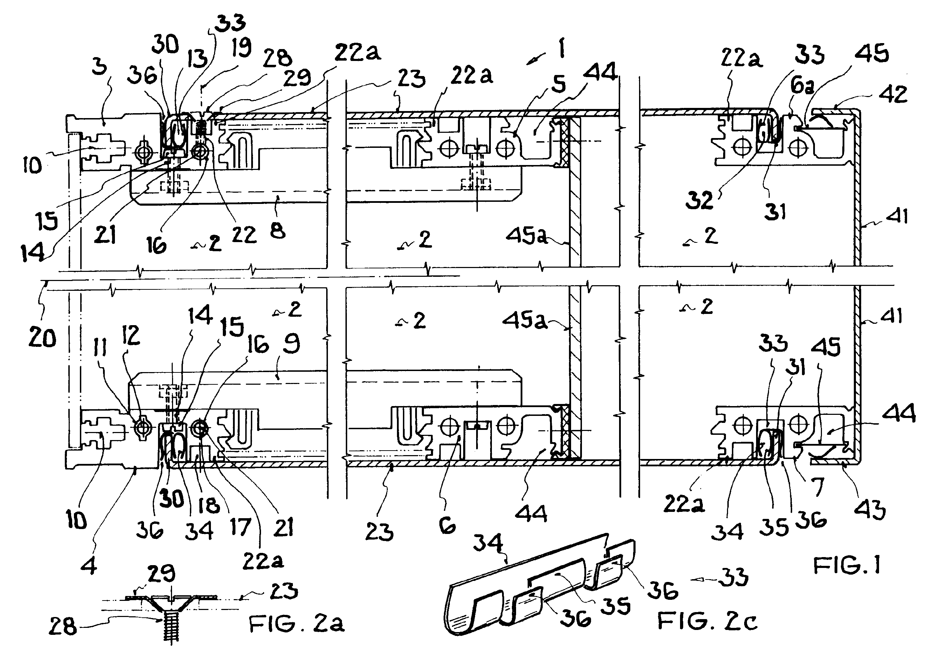

Die Profilschienen 3 bis 6, 6a und 7 bestehen aus Aluminium und sind z. B. im Stranggußverfahren hergestellt. An den Profilschienen 3 bis 6 sind parallel zueinander Führungshalter 8, 9 befestigt. Die Fig. 1 zeigt einen oberen Führungshalter 8, der an den Profilschienen 3 und 5 befestigt ist, und einen unteren Führungshalter 9, der an den Profilschienen 4, 6 befestigt ist. In ein Paar von sich gegenüberstehenden Führungshaltern 8, 9 werden Baugruppen in Form von flachen Steckbaugruppen eingesetzt. Derartige Baugruppen sind bekannt und nicht näher dargestellt. Die Baugruppen enthalten in der Regel eine Leiterplatte, die mit elektrischen bzw. elektronischen Bauelementen bestückt ist.

Um den für Baugruppen verfügbaren Raum im Baugruppenträger möglichst groß zu halten, sind die Profilschienen 3 bis 6 flach ausgebildet. Die an der Vorderseite des Baugruppenträgers angeordneten Profilschienen 3, 4 sind etwas anders ausgebildet als die Profilschienen 5, 6, 6a und 7 am rückwärtigen Ende des Baugruppenträgers 1. Die Profilschienen 3, 4 enthalten je eine sich über die gesamte Profilschienenlänge erstreckende Nut 10 von kreuzförmigem Querschnitt, die nach der flachen vorderen Stirnseite der Profilschiene 3, 4 offen ist und in ihren Querausbuchtungen Gleitmuttern oder Gewindeleisten aufnimmt, in die Schrauben eingefügt werden, mit denen die nicht näher dargestellten Frontleisten von Steckbaugruppen am Baugruppenträger befestigt werden. Die Steckbaugruppen werden hierdurch im Baugruppenträger fixiert. Die Nuten 10 beanspruchen eine gewisse Strecke in Tiefenrichtung der Profilschienen 3, 4. Es können auch andere Befestigungsmittel für die Steckbaugruppen an den Profilschienen vorgesehen sein.

Im Anschluß an die Nut 10 und im Abstand vom Nutgrund verläuft in den Profilschienen 3, 4 jeweils ein Loch 11, das sich über die gesamte Profilschienenlänge erstreckt. Diese Löcher sind für die Aufnahme von Schneidschrauben 12 bestimmt, mit denen die Seitenwände 2 an den Stirnseiten der Profilschienen 3, 4 angeschraubt werden.

Im Abstand von den Löchern 11 sind in den Profilschienen jeweils Nuten 13 vorhanden, die sich ebenfalls über die gesamte Profilschienenlänge erstrecken und nach oben bzw. unten offen sind.

Am Nutboden der Nuten 13 sind eine Reihe von in einem Rastermaß beabstandeten Löchern 14 vorgesehen. Die Löcher 14 sind für die Aufnahme von Schrauben 15 bestimmt, mit denen die Führungshalter 8, 9 an den Profilschienen 3, 4 angeschraubt werden. Seitlich neben den Nuten 13 und im Abstand von diesen befindet sich in den Profilschienen 3, 4 jeweils ein weiteres Loch 16, das sich über die gesamte Profilschienenlänge erstreckt. Die Löcher 16 sind für die Aufnahme weiterer Schneidschrauben 17 bestimmt, mit denen die Seitenwände 2 zusätzlich an den Profilschienen 3, 4 angeschraubt werden. Die Befestigung der Seitenwände 2 je an den Profilschienen 3, 4 mit zwei Schrauben 12, 17 verbessert die Stabilität.

Darüberhinaus werden die vorderen Schrauben 12 zusätzlich zur Befestigung von Seitenwinkeln 17a am Baugruppenträger 1 benutzt. Diese Seitenwinkel werden als Anschlag beim Einfügen des Baugruppenträgers 1 in ein Gestell oder einen Schrank benutzt. Die Seitenwinkel 17a können vom Baugruppenträger 1 durch Herausdrehen der Schrauben 12 gelöst werden, ohne daß dies die feste Verbindung der übrigen Baugruppenträgerteile beeinträchtigt. Dann können die Seitenwinkel 17a an den rückseiten Profilschienen 5, 6 oder 6a, 7 befestigt werden, um den Baugruppenträger 1 an seiner Rückseite mit einem tragenden Teil, z. B. einer Wand, zu verbinden. Durch die Befestigung der Seitenwinkel mittels Schrauben am Baugruppenträger und die Verwendung von zwei Schrauben 12, 17 je an einer Profilschiene 3 wird eine hohe Flexibilität in der Art der Montage des Baugruppenträgers 1 erreicht.

Parallel zum Loch 16 verläuft in jeder Profilschiene 3, 4 eine weitere Nut 18, die nach der den Führungshaltern 8, 9 abgewandten Profilschienenseite offen ist und einen rechteckigen Querschnitt hat. Die Nut 18 ist jeweils im Abstand vom Loch 16 angeordnet und weist die gleiche Mittelebene 19 wie das Loch 16 auf. Die Mittelebene 19 verläuft unter einem rechten Winkel zur mittleren Längsachse 20 des Baugruppenträgers 1. Unter Mittelebene 19 ist eine Ebene zu verstehen, die durch die Mitte der Nut 18 parallel zu den Seitenwänden und durch die Mittellinie 21 des Lochs 16 verläuft.

In das Loch 16 münden eine Reihe von Löchern 22 ein, die in einem Rastermaß nebeneinander angeordnet sind. Die Löcher 22 haben Mittelachsen, die in der Ebene 19 liegen und unter einem rechten Winkel zur Mittelachse 21 des Lochs 16 verlaufen.

In Tiefenrichtung des Baugruppenträgers 1 beanspruchen die Löcher 22 und 16 daher in den Profilschienen 3, 4 den gleichen Raum. Auf diese Weise wird eine Verkürzung der Profilschienen 3, 4 erreicht.

Die Löcher 22 sind für Befestigungsmittel bestimmt, die zum Verbinden von Abdeckblechen 23 an den Profilschienen 3, 4 verwendet werden. Die Abdeckbleche 23, die auf der Oberseite und der Unterseite des Baugruppenträgers 1 angebracht werden, dienen einerseits zum Schutz des Baugruppenträgerinneren und weisen andererseits Ausnehmungen für den Durchtritt von Kühluft auf.

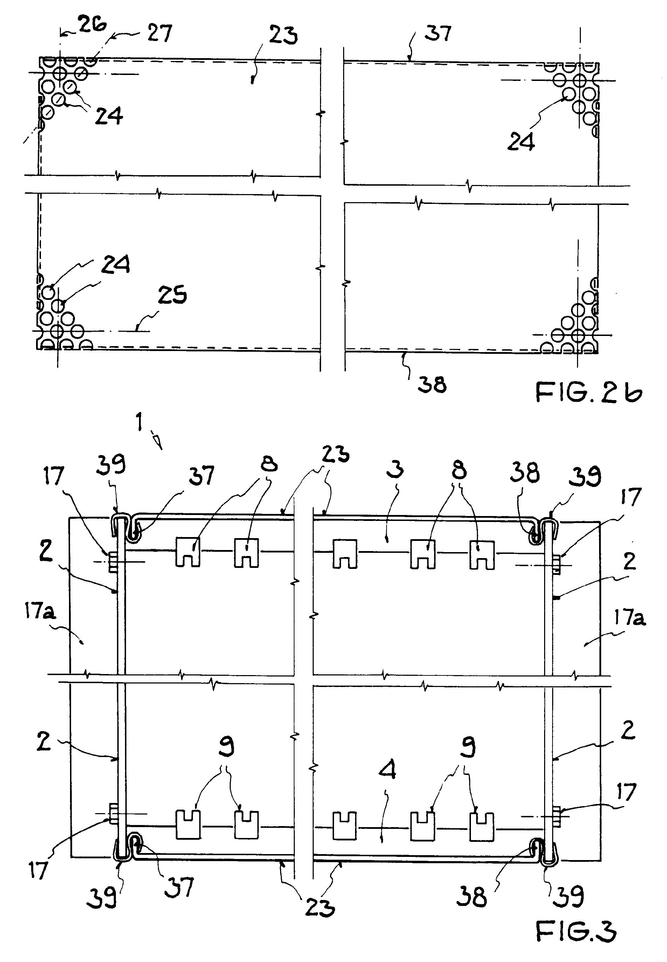

Die Ausnehmungen sind in dem in Fig. 2b dargestellten Abdeckblech, das für die obere und untere Abdeckung des Baugruppenträgers 1 geeignet ist, in Form von gleich großen Löchern 24 angeordnet, von denen in Fig. 2b nur einige dargestellt sind. Die Löcher 24 sind in parallelen Zeilen und Spalten angeordnet. Die in einer Zeile angeordneten Löcher 24 sind jeweils längs der gleichen Mittellinie 25 angeordnet. Auch die in einer Spalte angeordneten Löcher 24 erstrecken sich längs der gleichen Mittellinie 26 in gleichen Abstanden voneinander.

Darüberhinaus verlaufen die Löcher 24 längs der parallelen Diagonalen 27, die gegen die Ränder der Abdeckbleche 23 geneigt sind. Die Abdeckbleche 23 weisen daher ein regelmäßiges Lochmuster auf. Die Löcher 24 sind auf ein metrisches Normsystem abgestimmt und weisen z. B. 6,5 mm Durchmesser auf. Die Mitten der benachbarten Löcher 24 sind ebenfalls im Abstand des Normsystems, z. B. 12,5 mm voneinander entfernt. Auf die Mittenabstände der Löcher 24 der Abdeckbleche 23 sind die Mittenabstände der Löcher 22 abgestimmt, d. h. benachbarte Löcher 24 oder jedes dritte bzw. vierte Loch 24 kommt über ein entsprechendes Loch 22 zu liegen, wenn ein Abdeckblech 24 auf die Profilschienen 3, 5 bzw. 4, 6 gelegt wird und die Löcher 22, 24 aufeinander ausgerichtet werden. Deshalb werden die Löcher 24 auch für die Befestigung der Abdeckplatte 23 an den Profilschienen 3, 5 bzw. 4, 6 ausgenutzt.

Als Befestigungsmittel für die Abdeckbleche 23 werden Schrauben 28 eingesetzt, von denen eine in Fig. 2a im Querschnitt dargestellt ist. Die Schraube 28 hat einen tellerförmigen flachen Rand 29. Der tellerförmige Rand 29 kann mit der Schraube 28, die einen Schlitzkopf hat, untrennbar verbunden sein. Dies hat für die Vereinfachung der Montage Vorteile. Es ist aber auch möglich, den tellerförmigen Rand 29 als Unterlegscheibe zu verwenden. Der äußere Durchmesser des Rands 29 ist größer als der Durchmesser der Löcher 24. Der Schaft der Schraube 28 ist kleiner als der Durchmesser der Löcher 24.

Ebenso ist der Durchmesser der Löcher 22 kleiner als der Durchmesser der Löcher 24 und an den Schaft der Schrauben 28 angepaßt. Mehrere Schrauben 28, die vorzugsweise als Schneidschrauben ausgebildet sind, werden bei auf den Profilschienen 3, 5 bzw. 4, 6 aufliegenden Abdeckblechen 23 in Löcher 22 eingeschraubt.

Es werden dabei je Profilschiene mindestens zwei Schrauben 28 verwendet. In Fig. 1 ist der Baugruppenträger 1 mit je einem Abdeckblech 23 auf der Oberseite und Unterseite dargestellt. Das untere Abdeckblech 23 ist auf die gleiche Art wie das obere Abdeckblech befestigt, ohne daß Schrauben in Fig. 1 dargestellt sind.

Die Abdeckbleche 23 haben abgewinkelte Enden, von denen in Fig. 1 das vordere Ende 30 und das hintere Ende 31 dargestellt sind. Das vordere abgewinkelte Ende 30 ragt in die Nut 13. Das hintere Ende 31 ragt in eine Nut 32 der hintersten Profilschiene 6a.

Die Nuten 13 nehmen die Köpfe der Schrauben 28 auf, die stärker sind als die Durchmesser der Löcher 22. Die in die Löcher 22 eingeschraubten Schrauben 22 legen sich, wie in Fig. 1 gezeigt, mit ihren Rändern 29 an die Bereiche des Abdeckblechs 23 neben Löchern 24 an. Die Ränder 29 überragen das auf den Profilschienen 3, 5, 6 aufliegende Abdeckblech 23 nur wenig, so daß in der Höhe praktisch kein zusätzlicher Raumbedarf vorliegt. Eine ausreichende feste Verbindung wird mit Randstärken von z. B. 0,3 mm erreicht.

In die Nut 13 ist eine U-förmig ausgebildete Kontaktfeder 33 eingelegt, die in Fig. 2c näher perspektivisch dargestellt ist.

Die Kontaktfeder 33 enthält zwei Schenkel 34, 35, die sich jeweils an eine Wand der Nut 13 und an die Innenseite des abgewinkelte Endes 30 unter Federvorspannung anlegen und damit eine gut elektrisch leitende Verbindung zwischen dem Abdeckblech 23 und der Profilschiene 3 herstellen. Eine gleichartig leitende Verbindung ist in der Nut 32 mittels einer Kontaktfeder 33 vorhanden.

Die Kontaktfeder 33 enthält wenigstens zwei, vom Schenkel 35 nach außen vorspringende Finger 36. Die Finger 36 sind durch die Entfernung der seitlichen Verbindung von Schenkelabschnitten oder -streifen mit dem restlichen Schenke 35 und durch Vorbiegen der Abschnitte oder Streifen hergestellt.

Bei der Montage werden die Kontaktfedern 33 zuerst über die abgebogenen Enden 30 derart geschoben, daß die Ränder in den Spalt zwischen dem Schenke 35 und den Fingern 36 ragen. Die Kontaktfeder 33 hält sich aufgrund der Federwirkung zwischen Schenkel 35 und Finger 36 an den Enden. Danach wird das Ende 30 mit der daran befestigten Kontaktfeder 33 in die Nut 13 bzw. 32 eingefügt, wobei sich die Schenkel 34, 35 gegen die entsprechenden Wände der Nut 13 bzw. 32 und dem abgewinkelten Ende 30 legen.

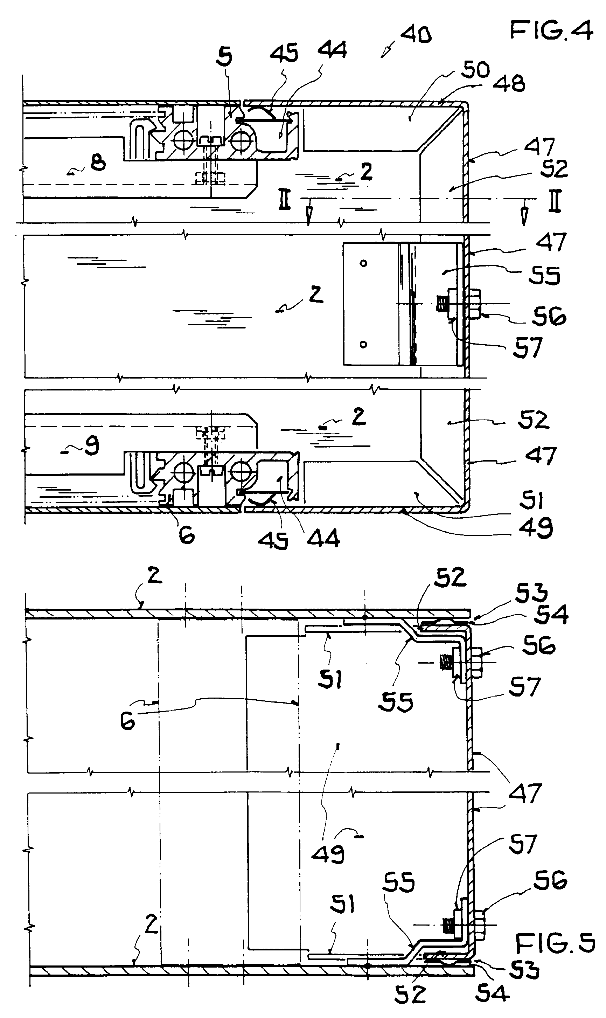

Die Abdeckbleche 23 weisen jeweils um 90 ° abgewinkelte seitliche Enden 37, 38 auf. Der Abstand zwischen den äußeren Seiten der beiden Enden 37, 38 ist kleiner als der Abstand zwischen den Innenflächen der Seitenwände 2. Infolgedessen stehen im montierten Zustand die Enden 37, 38 je mit ihren äußeren Oberflächen den Innenseiten der Wände 2 gegenüber. Dies ist aus Fig. 3 ersichtlich.

Leitende Kontaktfedern 39 mit S-förmigem Querschnitt stellen eine niederohmige Verbindung zwischen den metallischen Seitenwänden 2, die aus Blech, z. B. elexiertem Aluminiumblech, hergestellt sind und den Abdeckblechen 23 her, die aus dem gleichen Material hergestellt sein können. Die S-förmigen Kontaktfedern 39 legen sich mit einer Hälfte je um die oberen bzw. unteren Ränder der Seitenwände unter Federvorspannung. Mit der anderen Hälfte legen sich die Kontaktfedern 39 um die Ränder der abgewinkelten Enden 37, 38.

Vor der Montage des Baugruppenträgers 1 werden die Kontaktfedern z. B. an den Rändern der Abdeckbleche 23 befestigt.

Bei der in Fig. 3 dargestellten Vorrichtung sind keine Schraubverbindungen für die Befestigung der Abdeckbleche 23 an den Seitenwänden 2 notwendig. Die Kontaktfedern 39 können von Hand an den Rändern der Seitenwände 2 oder der Enden 37, 38 angebracht werden, worauf sie unter Federvorspannung haften bleiben. Bei der Montage lassen sich die freien Ränder der Gegenstücke schnell und einfach in die entsprechenden Hälften der Kontaktfedern 39 einschieben. Die Montagezeiten für den Baugruppenträger 1 können hierdurch verkürzt werden.

Die in Fig. 3 dargestellte Anordnung kann für sich, d. h. ohne die in Fig. 1, 2a und 2c dargestellte Art der Befestigung der vorderen bzw. hinteren Enden der Abdeckbleche 23 bei Baugruppenträgern verwendet werden.

Mit der in Fig. 1 bis 3 gezeigten Vorrichtung ist es möglich, Abdeckbleche 23 aus Bahnen, die das in Fig. 2b gezeigte Lochmuster aufweisen, in den für die verschieden großen Baugruppenträger benötigten Abmessungen auszuschneiden, wobei die Schnittkanten längs der Mittellinie der Löcher einer Spalte bzw. einer Zeile liegen können. Lediglich durch Abbiegen der Ränder wird dann ein so geformtes ebenes Lochblech in die notwendige Abdeckblechform gebracht. Hierdurch wird die Fertigung vereinfacht.

Die Fig. 4 und 5 zeigen den rückwärtige Teil eines Baugruppenträgers 40, der gegen störende elektromagnetische Felder auf seiner Rückseite anders geschützt ist als der Baugruppenträger gem. Fig. 1. Bei dem Baugruppenträger gem. Fig. 1 ist an den rückseitigen Profilschienen 6a, 7 eine Haube 41 befestigt, die an die rückseitigen Stirnflächen der Profilschienen 6a, 7 angrenzt und mit diesen durch nicht gezeigte Mittel, z. B. Schrauben, verbunden ist. Die Haube 41 mit ebenem Boden und um 90 ° abgewinkelten oberen und unteren Rändern 42, 43 grenzt einerseits an die bündig mit den hinteren Enden der Profilschienen 6a, 7 die bündig mit den hinteren Enden der Profilschienen 6a, 7 verlaufenden Seitenwände 2 und an die Abdeckbleche 23, die um wenigstens die Länge der Enden 43 gegen die hinteren Stirnseiten der Profilschienen 6a, 7 zurückgesetzt sind. Die Profilschienen 6a, 7 weisen ebenso wie die Profilschienen 5, 6 nahe an ihren rückseitigen Enden größere Nuten 44 auf, die nach der Baugruppenoberseite bzw. Baugruppenunterseite hin offen sind. Die Ränder 42, 43 überdecken die Nuten 44 zum größten Teil. In den Nuten 44 sind V-förmige Federn 45 in nicht näher bezeichneten Querausnehmungen gehalten. Ein Schenkel der Federn 45 legt sich unter Federvorspannung an den jeweiligen Rand 42 bzw. 43 an und stellt eine niederohmig leitende Verbindung zwischen der Haube 41 und den Profilschienen 6a, 7 her. In Fig. 1 ist auch die Möglichkeit des Abschlußes des Baugruppenträgers hinter den Profilschienen 5, 6 durch eine Haube 45a angedeutet, die dann in gleicher Weise wie die Haube 41 ausgebildet ist. Die Profilschienen 5, 6 und 6a, 7 stimmen auch im Aufbau bzw. in der Form überein.

Deshalb wird die zur Abschirmung dienende Abdeckung bei den Profilschienen 5 und 6 in Fig. 1 nicht im einzelnen dargestellt und beschrieben. Falls der Baugruppenträger die kürzere Form hat, sind dann die Seitenwände und Abdeckbleche entsprechend kürzer. Das untere Abdeckblech 23 ist auf die gleiche Weise wie das ebene Abdeckblech mit dem Baugruppenträger 1 an den Profilschienen 4, 6 bzw. 7 befestigt. Nähere Einzelheiten der Befestigung sind aus Fig. 1 in Verbindung mit der Profilschiene 3 ersichtlich. Die Abdeckbleche 23 sind mit den Profilschienen 4, 5, 6, 6a und 7 auf die gleiche Weise wie das Abdeckblech mit der Profilschiene 3 verbunden, weshalb die Verbindungen an den entsprechenden Stellen nicht im einzelnen dargestellt und beschrieben sind.

Gemäß Fig. 4 sind die Profilschienen 5 und 6 mit den Nuten 44 versehen, in denen die Federn 45 in gleicher Weise wie in Fig. 1 gezeigt angeordnet sind. Eine rückwärtige Abdeckhaube 46 weist eine ebene Bodenplatte 47 und eine obere Seitenwand 48 sowie eine untere Seitenwand 49 auf. Die Seitenwände 48, 49 sind auf den hinter den Profilschienen 5, 6 benötigten Raum abgestimmt, in dem sich die rückwärtigen Pfosten der Federleisten und andere Bauteile, z. B. Übergabesteckverbinder, befinden können. Die beiden Seitenwände 2 erstrecken sich bis zur Bodenplatte 47. Die Seitenwände 48, 49 sind rechtwinklig von der Bodenplatte 47 abgewinkelt. Die Seitenwände 48, 49 haben jeweils rechtwinklig zur Innenseite des Baugruppenträgers hin abgewinkelte Randzonen 50, 51, von denen in Fig. 4 nur jeweils eine dargestellt ist. Ebenso hat die Bodenplatte 47 rechtwinklig abgewinkelte Randzonen 52, von denen in Fig. 4 nur eine dargestellt ist. Die Randzonen 50, 51, 52 sind gegenüber den Seitenwänden 2 so weit zum Baugruppenträgerinneren zurückgesetzt, daß ein in Fig. 4 und 5 mit 53 bezeichneter Spalt vorhanden ist. Auf den Außenseiten der Randzonen 50, 51, 52 sind gewölbte Federn 54 befestigt. Die Befestigung kann durch Kleben erfolgen. Die Federn 54 legen sich bei am Baugruppenträger 40 befestigter Abdeckhaube 46 an die Seitenwände 2 an und bewirken eine gut leitende elektrische Verbindung zur Abschirmung von störenden elektromagnetischen Feldern.

An den Seitenwänden 2 sind jeweils Montagewinkel 55 befestigt, die sich über nur einen geringen Teil der Höhen der Seitenwände 2 erstrecken.

Die Montagewinkel 55 sind z. B. angelötet, angeschweißt oder angeschraubt und haben rechtwinklig in die Ebene der Bodenplatte 47 abgebogene Enden, an denen die Bodenplatte 47 mittels Schrauben 56 und Muttern 57 angeschraubt ist.

Die in Fig. 4 und 5 dargestellte Art des Schutzes der rückwärtigen Teile eines Baugruppenträgers läßt sich auch unabhängig von der oben beschriebenen Art der Abschirmung durch Abdeckplatte 23 einsetzen und erlaubt mit einfachen Mitteln eine wirksame Dämpfung störender elektromagnetischer Felder sei es, daß sie im Inneren des Baugruppenträgers entstehen, oder sei es, daß sie von außen auf den Baugruppenträger einwirken.

## Patentansprüche

1. Baugruppenträger (1) für elektrische Baugruppen mit zwei Seitenwänden (2), zwischen denen wenigstens vier Profilschienen (3,4,5,6,6a,7) angeordnet sind, deren Stirnseiten nahe an den Ecken der Seitenwände an diesen befestigt sind, wobei mit den Profilschienen Führungshalter (8,9) verbunden sind, in die die elektrischen Baugruppen einsetzbar sind,
**dadurch gekennzeichnet**,
daß in einem Abschnitt der jeweiligen Profilschiene (3, 4, 5, 6, 6a, 7), der ein in Längsrichtung verlaufendes Loch (16) für Schraubbefestigungen der Seitenwände (2) aufweist, in das genannte Loch (16) einmündende, mit den Mittellinien (19) rechtwinklig zur Mittellinie (21) dieses Lochs (16) verlaufende Löcher (22) vorgesehen sind, die von einer Auflagefläche (22a) der Profilschiene (3, 4, 5, 6, 6a, 7) für ein Abdeckblech (23) aus zum Befestigen des Abdeckblechs (23) zugänglich sind.

2. Baugruppenträger nach Anspruch 1,
**dadurch gekennzeichnet**,
daß die Löcher (22) nahe an der Auflagefläche (22a) in eine Ausnehmung übergehen, die an Köpfe von Schrauben (28) mit tellerförmigen Rändern (29) angepaßt ist und daß die Ränder im Durchmesser größer sind als Durchlässe für Schrauben im Abdeckblech.

3. Baugruppenträger nach Anspruch 1 oder 2,
**dadurch gekennzeichnet**,
daß die Abdeckbleche (23) mit Löchern (24) für den Luftdurchlaß versehen sind, die im Raster eines genormten Maßes gleichmäßig auf dem jeweiligen Abdeckblech verteilt sind, und daß die Löcher (22) in den Profilschienen (3, 4, 5, 6, 6a, 7) in einer Reihe in gleichem Raster oder einem Vielfachen des Rasters angeordnet sind wie die in einer Reihe angeordneten Löcher (24) der Abdeckbleche (23).

4. Baugruppenträger nach einem oder mehreren der vorhergehenden Ansprüche,
**dadurch gekennzeichnet**,
daß die Profilschienen (3, 4, 5, 6, 6a, 7) jeweils eine in Längsrichtung verlaufende, im Abstand von der Reihe der Löcher (22) angeordnete, von einer baugruppenaußenseitig angeordneten Profilschienenbreitseite ausgehende Nut (13) enthalten, in die abgewinkelte Enden (30) der Abdeckbleche (23) ragen und durch Kontaktfedern (33) elektrisch leitend mit mindestens einer Wand der Nut (13) verbunden sind.

5. Baugruppenträger, nach einem oder mehreren der vorhergehenden Ansprüche,
**dadurch gekennzeichnet**,
daß die Kontaktfedern (33) U-förmig geformt sind und ein Schenkel (35) der Kontaktfedern (33) wenigstens einen federnd vorspringenden Finger (36) enthält.

6. Baugruppenträger nach Anspruch 5,
**dadurch gekennzeichnet**,
daß der Finger (36) durch Einschneiden seitlicher Schlitze in den Schenkel (35) und Vorbiegen hergestellt ist.

7. Baugruppenträger, nach einem oder mehreren der vorhergehenden Ansprüche,
**dadurch gekennzeichnet**,
daß das jeweils oben oder unten am Baugruppenträger (1) angeordnete Abdeckblech (23) parallel zu den Seitenwänden (2) des Baugruppenträgers (1) verlaufende, abgewinkelte Enden (37, 38) hat, die den Innenseiten der Seitenwände (2) gegenüberstehen, und daß je eine, einen S-förmigen Querschnitt aufweisende Kontaktfeder (39) die Längsränder einer Seitenwand (2) und eines abgewinkelten Endes (37, 38) umgreift.

8. Baugruppenträger, nach einem oder mehreren der vorhergehenden Ansprüche,
**dadurch gekennzeichnet**,
daß eine rückseitige Abdeckhaube (46) am Baugruppenträger (1) an die rückseitige Ausdehnung des Baugruppenträgerabdeckraums angepaßte, mit abgewinkelten oberen und unteren Randzonen (50, 51) versehene Wände (48, 49) hat, deren Randbereiche jeweils mit einer der rückseitigen Profilschienen durch in Profilschienennuten (44) eingesetzte, leitende Federn (45) kontaktiert sind, daß die sich bis zum Ende des Baugruppenträgerabdeckraums erstreckenden Seitenwände (2) mit den Randzonen (50, 51) über Federn (54) leitend verbunden sind und daß eine rückwärtige Bodenplatte (47) der Abdeckhaube abgewinkelten Randzonen (52) hat, die den Innenseiten der Seitenwände unter Zwischenschaltung elektrisch leitender Federn (54) gegenüberstehen.

9. Baugruppenträger nach Anspruch 8,
**dadurch gekennzeichnet**,
daß die beiden Seitenwände nahe an ihren rückseitigen Enden zum Inneren des Baugruppenträgers hingerichtete Befestigungswinkel (55) aufweisen, an denen die Bodenplatte (47) der Abdeckhaube (46) anschraubbar ist.

10. Baugruppenträger nach Anspruch 8 oder 9,
**dadurch gekennzeichnet**,
daß die Federn (54) zwischen den Randzonen (50, 51, 52) und den Seitenwänden an die Randzonen angeklebt sind.

## Claims

1. Subassemblies carrier (1) for electrical subassemblies, with two side walls (2), between which are arranged at least four profile rails (3, 4, 5, 6, 6a, 7), the end faces of which are fastened to the side walls in the vicinity of the corners thereof, wherein guide mounts (8, 9), into which the electrical subassemblies are insertable, are connected with the profile rails, characterised thereby that provided in a section of the respective profile rail (3, 4, 5, 6, 6a, 7), which has a hole (16) extending in longitudinal direction for screw fastenings of the side walls (2), are holes (22) which open into the said hole (16), extend with the centre lines (19) at right angles to the centre line (21) of this hole (16) and are accessible, from a support surface (22a) of the profile rail (3, 4, 5, 6, 6a, 7) for a cover plate (23), for the fastening of the cover plate (23).

2. Subassemblies carrier according to claim 1, characterised thereby that in the vicinity of the support surface (22a) the holes (22) go over into a recess which is matched to heads of screws (28) with plate-shaped edges (29) and that the edges are larger in diameter than passages for screws in the cover plate.

3. Subassemblies carrier according to claim 1 or 2, characterised thereby that the cover plates (23) are provided with holes (24) for the passage of air, which holes are distributed uniformly on the respective cover plate in the grid pattern of a standard dimension, and that the holes (22) in the profile rails (3, 4, 5, 6, 6a, 7) are arranged in a row in the same grid pattern, or a multiple of the grid pattern, as the holes (24), which are arranged in a row, of the cover plate (23).

4. Subassemblies carrier according to one or more of the preceding claims, characterised thereby that the profile rails (3, 4, 5, 6, 6a, 7) each contain a respective groove (13), which extends in longitudinal direction, is arranged at a spacing from the row of holes (22), goes out from a profile rail wide side arranged at the subassembly outer side and in which angled ends (30) of the cover plate (23) project and are electrically conductively connected with at least one wall of the groove (13) by contact springs (33).

5. Subassemblies carrier according to one or more of the preceding claims, characterised thereby that the contact springs (33) are formed to be U-shaped and a limb (35) of the contact springs (33) comprises at least one resilient projecting finger (36).

6. Subassemblies carrier according to one or more of the preceding claims, characterised thereby that the finger (36) is produced by incision of lateral slots in the limb (35) and bending forward.

7. Subassemblies carrier according to one or more of the preceding claims, characterised thereby that the cover plate (23) arranged above or below at the subassemblies carrier (1) has angled ends (37, 38), which extend parallel to the side walls (2) of the subassemblies carrier (1) and are disposed opposite the inward sides of the side walls (2), and that each contact spring (39), which has an S-shaped cross-section, engages around the longitudinal edges of a side wall (2) and of an angled end (37).

8. Subassemblies carrier according to one or more of the preceding claims, characterised thereby that a rear-sided cover hood (46) at the subassemblies carrier (1) has walls (48, 49), which are matched to the rear-sided extension of the subassemblies carrier cover space, are provided with angled upper and lower edges zones (50, 51) and the edge regions of which are each contacted with one of the rear-sided profile rails by conductive springs (45) inserted into profile rail grooves (44), that the side walls (2) extending up to the end of the subassemblies carrier cover space are conductively connected with the edge zones (50, 51) by way of springs (54) and that a rearward base (47) of the cover hood has angled edge zones (52), which are disposed opposite the inward sides of the side walls with interposition of electrically conductive springs (54).

9. Subassemblies carrier according to claim 8, characterised thereby that the two side walls have in the vicinity of their rear-sided ends fastening angle brackets (55) which are directed towards the interior of the subassemblies carrier and to which the base plate (47) of the cover hood (46) is screw-connectible.

10. Subassemblies carrier according to claim 8 or 9, characterised thereby that the springs (54) between the edge zones (50, 51, 52) and the side walls are glued to the edge zones.

## Revendications

1. Châssis de support (1) pour composants électriques comportant deux parois latérales (2) entre lesquelles sont disposés au moins quatre rails profilés (3, 4, 5, 6, 6a, 7) dont les faces frontales sont fixées à proximité des angles des parois latérales, les rails profilés étant reliés à des supports de guide (8, 9) dans lesquels les composants électriques sont insérables,
caractérisé en ce que
dans une section des rails profilés respectifs (3, 4, 5, 6, 6a, 7), qui présente un trou longitudinal (16) pour des fixations par vis des parois latérales (2), il est prévu des trous (22) qui débouchent dans ledit trou (16), dont les lignes médianes (19) s'étendent à angle droit par rapport à la ligne médiane (21) de ce trou (16) et qui sont accessibles par une face d'application (22a) du rail profilé (3, 4, 5, 6, 6a, 7) pour une tôle de recouvrement (23) en vue de la fixation de la tôle de recouvrement (23).

2. Châssis de support pour composants selon la revendication 1,
caractérisé en ce que
les trous (22) se transforment, à proximité de la surface d'application (22a), en une cavité qui est adaptée aux têtes de vis (28) comprenant des bords (29) formant collerette et en ce que les diamètres des bords sont plus grands que les passages des vis dans la tôle de recouvrement.

3. Châssis de support pour composants selon la revendication 1 ou 2,
caractérisé en ce que
les tôles de recouvrement (23) sont munies de trous (24) pour le passage de l'air qui sont répartis, en réseau de norme standard, régulièrement sur la tôle de recouvrement respective et en ce que les trous (22) des rails profilés (3, 4, 5, 6, 6a, 7) sont disposés sur une rangée dans le même réseau ou dans un multiple du réseau, comme le sont les trous (24) des tôles de recouvrement (23) disposés sur une rangée.

4. Châssis de support pour composants selon l'une ou plusieurs des revendications précédentes,
caractérisé en ce que,
les rails profilés (3, 4, 5, 6, 6a, 7) comprennent respectivement une rainure (13) s'étendant longitudinalement, à distance de la rangée des trous (22) et partant d'une face large des rails profilés disposée sur la face externe côté composants, rainure dans laquelle s'engagent les extrémités coudées (30) des tôles de recouvrement (23), extrémités qui sont reliées, de manière conductrice électriquement par des ressorts de contact (33), à au moins une paroi de la rainure (13).

5. Châssis de support pour composants selon l'une ou plusieurs des revendications précédentes,
caractérisé en ce que
les ressorts de contact (33) ont une forme en U et en ce qu'au moins une branche de U (35) des ressorts de contact (33) comprend au moins un doigt (36) saillant de manière élastique.

6. Châssis de support pour composants selon la revendication 5,
caractérisé en ce que
le doigt (36) est réalisé par l'entaille de fentes latérales dans les branches (35) et par précambrage.

7. Châssis de support pour composants selon l'une ou plusieurs des revendications précédentes,
caractérisé en ce que
la tôle de recouvrement (23), disposée en haut ou en bas sur le châssis de support (1) de composants, présente des extrémités coudées (37, 38) qui s'étendent parallèlement aux parois latérales (2) du châssis de support (1) pour composants et qui sont opposées aux faces internes des parois latérales (2) et en ce qu'un ressort de contact (39), présentant une coupe transversale en S, entoure les bords longitudinaux d'une paroi latérale (2) et d'une extrémité coudée (37, 38).

8. Châssis de support pour composants selon l'une ou plusieurs des revendications précédentes,
caractérisé en ce qu'
un capot de recouvrement arrière (46) sur le châssis de support (1) de composants présente des parois (48, 49) qui sont adaptées à la cavité arrière de l'espace de recouvrement du châssis de support de composants, qui sont munies de zones de bordures (50, 51) coudées supérieures et inférieures et dont les zones de bordures entrent en contact avec l'un des rails profilés arrière par l'intermédiaire de ressorts (45) conducteurs, insérés dans des rainures (44) des rails profilés, en ce que les parois latérales (2), s'étendant jusqu'à l'extrémité de l'espace de recouvrement du châssis de support de composants, sont reliées de manière conductrice aux zones de bordures (50, 51) par des contacts (54) et en ce qu'une plaque de fond arrière (47) du capot de recouvrement présente des zones de bordures coudées (52) qui sont opposées aux faces internes des parois latérales et entre lesquelles interviennent des ressorts (54) électriquement conducteurs.

9. Châssis de support pour composants selon la revendication 8,
caractérisé en ce que
les deux parois latérales présentent, à proximité de leurs extrémités arrière, des équerres de fixation (55) qui sont dirigées vers l'intérieur du châssis de support pour composants et sur lesquelles peut être vissée la plaque de fond (47) du capot de recouvrement (46).

10. Châssis de support de composants selon la revendication 8 ou 9, caractérisé en ce qu'
entre les zones de bordures (50, 51, 52) et les parois latérales, les ressorts (54) sont collés contre les zones de bordure.
